(19)

Europäisches
Patentamt
European
Patent Office
Office européen
des brevets

(11) **EP 1 876 591 A2**

(12) **EUROPEAN PATENT APPLICATION**

(43) Date of publication:
**09.01.2008 Bulletin 2008/02**

(51) Int Cl.:
*G11B 7/0065* [(2006.01)]   *G03H 1/04* [(2006.01)]
*G11C 13/04* [(2006.01)]

(21) Application number: **07013130.5**

(22) Date of filing: **04.07.2007**

<table>
<tr><td>

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **05.07.2006 JP 2006185840
15.05.2007 JP 2007129514**

</td><td>

(71) Applicant: **Sharp Kabushiki Kaisha
Osaka-shi, Osaka 545-8522 (JP)**

(72) Inventor: **Nakamura, Atsushi
Nara 631-0033 (JP)**

(74) Representative: **Müller - Hoffmann & Partner
Patentanwälte,
Innere Wiener Strasse 17
81667 München (DE)**

</td></tr>
</table>

(54) **Hologram recording device, hologram reproducing device and hologram recording method not requiring positioning of a phase mask**

(57)   A spatial light modulator (202) spatially modulates a laser beam (201) to provide an object beam (203) representing information to be recorded and having a predetermined frequency component, and spatially modulates a laser beam (201) to provide a record reference beam (204) having a frequency component equal to the predetermined frequency component. An objective lens (205) simultaneously converges the object beam (203) and the record reference beam (204) on a record medium (200).

FIG. 1

EP 1 876 591 A2

## Description

This nonprovisional application is based on Japanese Patent Applications Nos. 2006-185840 and 2007-129514 filed with the Japan Patent Office on July 5, 2006 and May 15, 2007, respectively, the entire contents of which are hereby incorporated by reference.

BACKGROUND OF THE INVENTION

Field of the Invention

The present invention relates to a hologram recording device, a hologram reproducing device and a hologram recording method, and particularly to a method of modulating a record reference beam and a reproduction reference beam.

Description of the Background Art

In recent years, a hologram technology has received attention as a possible major storage competing with next- and post-next-generation optical disks. For putting the hologram technology to actual use, a hologram record/reproduction system that performs record/ reproduction of a large amount of data using the hologram technology has bee proposed, e.g., in IBM J. RES. DEVELOP, VOL. 44, No. 3, MAY 2000, "Holographic Data Storage". This hologram record/reproduction device causes interference between an object beam modulated based on record data and a reference beam to produce an interference fringe, and records the interference fringe on a hologram record medium.

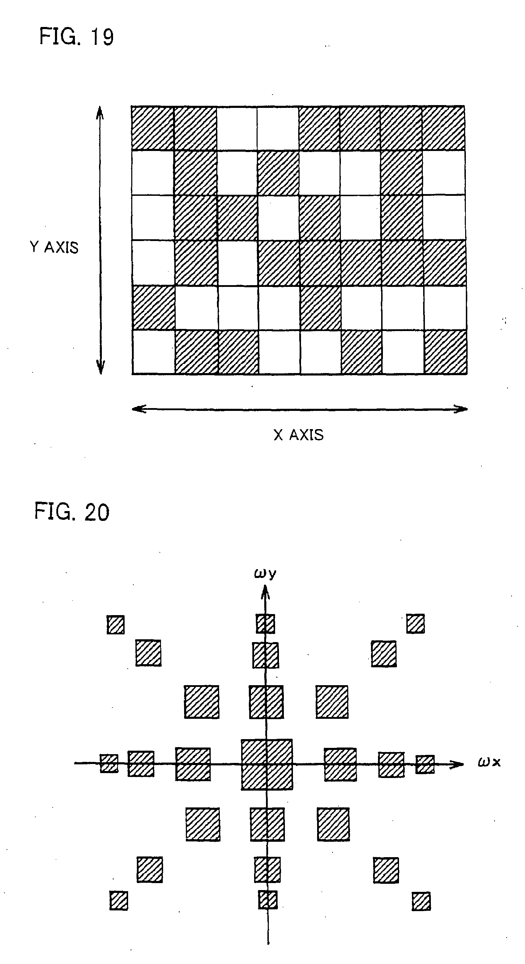

It is assumed that object beams from an image illustrated in Fig. 19. In a digital hologram memory, a Fourier transform image of a data image is recorded by lenses for achieving a high record density. This is proportional to the Fourier transform of an amplitude distribution of the data image illustrated in Fig. 19, and therefore is referred to as a "Fourier transform hologram".

Fig. 20 illustrates a Fourier transform image of a data image. A spread $\zeta$ in an x-axis direction of the Fourier transform image can be obtained by the following equation (1).

$$\zeta = k \times \lambda \times f \times \omega x \cdots (1)$$

where $\zeta$ represents the spread of the Fourier transform image of the data image (signal beams), k represents a proportionality factor, $\lambda$ represents a wavelength of the signal beam, f represents a focal length of a lens for the Fourier transform, $\omega x$ represents a spatial frequency of the signal beam in an x-axis direction.

The spread of the Fourier transform image in the x-axis direction illustrated in Fig. 20 corresponds to spatial frequency $\omega x$ in the x-axis direction of the data image illustrated in Fig. 19. In the x-axis direction, the Fourier transform image spreads symmetrically in the positive and negative directions with respect to a zeroth beam (low frequency component) in a position of ($\omega x = 0$) and ($\omega y = 0$). The same is true with respect to the y-axis direction. As described above, the spatial frequency has positive and negative values, and only the positive or negative components are required for recording and reproducing the data image of the object beams.

For recording and reproducing only image edge portions of the object beams, it is possible to intercept the DC components of the spatial frequency, i.e., the zeroth beams ($\omega x = 0$). Thus, the image edge portion of the object beams can be recorded and reproduced by taking out and recording only, e.g., the positive components ($\infty > \omega x > 0$).

Further, the image (object beams) to be recorded is not an analog data image but a binary digital data image. Therefore, it is not necessary to take out and record the components having a spatial frequency $\omega x$ of an infinite value, and it is merely required to record substantially the components of spatial frequencies having a period of about one pixel of the digital data image.

In the process of recording the information with the hologram, therefore, a quality of a reproduced image depends on a range or extent of the spatial frequency components which are used for interference with the reproduction beams to contribute to formation of interference fringe. Therefore, a phase mask is inserted into an optical path of a reference beam for changing the reference beam used for the record/reproduction into a spectral fashion in some cases (see Japanese Patent Laying-Open No. 2005-241773).

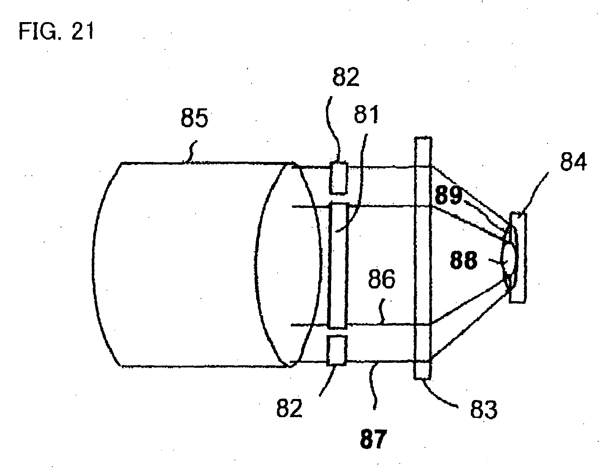

Japanese Patent Laying-Open No. 2005-241773 has disclosed a manner which performs, as shown in Fig. 21, pupil division by arranging phase masks 82 around a spatial optical modulator (liquid crystal panel) 81. Laser beams 85 that are emitted from a laser beam source (not shown) and are collimated by a beam expander or the like enter spatial optical modulator 81 and phase masks 82 arranged above and below spatial optical modulator 81. Spatial optical modulator 81 performs intensity modulation on the incoming laser beams according to a displayed data page pattern to produce object beams 86, which are converged to a record spot (representing a three-dimensional range in this example) 88 of a hologram record medium 84 (e.g., of photopolymer) by a Fourier transform lens 83. At the same time, laser beams 85 entering phase masks 82 change into record reference beams 87 (i.e., reference beams for record) in a spectral form, and record reference beams 87 are converged by Fourier transform lens 83 onto a spot 89 of hologram record medium 84. Thereby, an interference fringe caused by the interference between object beams 86 and record reference beams 87 is recorded on record spot 88 of hologram record medium 84. In this operation, record reference beams 87 applied to spot 89 have a spectral form, and thus form a light flux that diverges to a certain extent.

However, in the hologram record/reproduction device that uses the phase masks as disclosed in Japanese Patent Laying-Open No. 2005-241773, a wave surface of the reference beam used for the record/reproduction may deviate due to deviation of a position of the phase masks. Thus, the phase masks cannot be positioned with respect to the light flux of the reference beams without difficulty.

When the record medium is irradiated with the beams, a total quantity (i.e., a dynamic range) of possible reaction with the light is generally limited, and it is desired to utilize the limited dynamic range as efficiently as possible. More specifically, it is desired to reduce an exposure quantity that is required in each exposing operation for recording information on the record medium (i.e., to reduce applied light quantities of the object beams and reference beams applied per operation) as far as possible. However, when the phase masks are inserted into the reference beams as disclosed in Japanese Patent Laying-Open No. 2005-241773, the reference beams spread on the light collecting spot, and provides unnecessary refractivity modulation to the record medium, resulting in a problem that the dynamic range is wasted.

SUMMARY OF THE INVENTION

Accordingly, an object of the invention is to provide a hologram recording method and a hologram recording device that record information without requiring positioning of a phase mask and without causing spreading of reference beams on a light collecting spot, and is to provide a hologram reproducing method and a hologram reproducing device that reproduce the information thus recorded.

The invention provides a hologram recording device for applying an object beam representing information and a record reference beam to a record medium to record the information by recording, on the record medium, an interference fringe caused by the object beam and the record reference beam, including a spatial light modulator spatially modulating a light flux; and a lens converging the modulated light flux onto the record medium. The spatial light modulator includes a first spatial light modulator spatially modulating the light flux to provide the object beam representing the information to be recorded and having a predetermined frequency component, and a second spatial light modulator spatially modulating the light flux to provide the record reference beam having a frequency component equal to the predetermined frequency component at least in a region except for a low frequency component. The lens simultaneously converges the object beam and the record reference beam onto the record medium.

Preferably, the first and second spatial light modulators perform amplitude modulation on the incoming light flux.

Preferably, the object beam and the record reference beam are spatially modulated in the same modulation method.

Preferably, the object beam and the record reference beam are spatially modulated in different modulation methods, respectively, and a maximum number of neighboring bright spots in the modulation applied to the object beam is equal to that in the modulation applied to the record reference beam.

Preferably, a peak position of an envelope, in a region except for a low frequency component, of an intensity distribution of the record reference beam on a Fourier surface matches a peak position of an envelope, in the region, of an intensity distribution of the object beam on the Fourier surface.

The invention provides a hologram reproducing device for reading information from a record medium bearing an interference fringe caused by an object beam representing the information and a record reference beam, including a spatial light modulator spatially modulating a light flux to provide a reproduction reference beam having the same frequency component as the object beam at least in a region except for a low frequency component, and a lens converging the reproduction reference beam onto the record medium.

Preferably, the spatial light modulator performs amplitude modulation on the incoming light flux.

Preferably, the reproduction reference beam is spatially modulated in the same modulation method as the object beam.

Preferably, the reproduction reference beam is spatially modulated in a modulation method different from that of the object beam, and a maximum number of neighboring bright spots in the modulation applied to the object beam is equal to that in the modulation applied to the reproduction reference beam.

Preferably, a peak position of an envelope, in a region except for a low frequency component, of an intensity distribution of the reproduction reference beam on a Fourier surface matches a peak position of an envelope, in the region, of an intensity distribution of the object beam on the Fourier surface.

The invention provides a hologram recording method for applying an object beam representing information and a record reference beam to a record medium to record the information by recording, on the record medium, an interference fringe caused by the object beam and the record reference beam, including the steps of: spatially modulating a light flux; and converging the modulated light flux onto the record medium. In the step of performing the modulation, the light flux is spatially modulated to provide the object beam representing the information to be recorded and having a predetermined frequency component, and the light flux is spatially modulated to provide the record reference beam having the same frequency component as the object beam at least in a region except for a low frequency component. In the step of converging the light flux, the object beam and the record reference beam are simultaneously converged onto the record medium.

Preferably, amplitude modulation is performed on the incoming light flux in the step of performing the modulation.

Preferably, the object beam and the record reference beam are spatially modulated in the same modulation method in the step of performing the modulation.

Preferably, in the step of performing the modulation, the object beam and the record reference beam are spatially modulated in different modulation methods, respectively, and a maximum number of neighboring bright spots in the modulation applied to the object beam is equal to that in the modulation applied to the record reference beam.

Preferably, the object beam and the record reference beam provided in the step of performing the modulation are configured such that a peak position of an envelope, in a region except for a low frequency component, of an intensity distribution of the record reference beam on a Fourier surface matches a peak position of an envelope, in the region, of an intensity distribution of the object beam on the Fourier surface..

The invention provides a hologram reproducing method for reading information from a record medium bearing an interference fringe caused by an object beam representing the information and a record reference beam, including the steps of: spatially modulating a light flux to provide a reproduction reference beam having the same frequency component as the object beam at least in a region except for a low frequency component; and converging the reproduction reference beam onto the record medium.

Preferably, amplitude modulation is performed on the incoming light flux in the step of performing the modulation.

Preferably, the reproduction reference beam and the object beam are spatially modulated in the same modulation method in the step of performing the modulation.

Preferably, in the step of performing the modulation, the reproduction reference beam is spatially modulated in a modulation method different from that of the object beam, and a maximum number of neighboring bright spots in the modulation applied to the object beam is equal to that in the modulation applied to the reproduction reference beam.

Preferably, in the step of performing the modulation, the reproduction reference beam is provided such that a peak position of an envelope, in a region except for a low frequency component, of an intensity distribution of the reproduction reference beam on a Fourier surface matches a peak position of an envelope, in the region, of an intensity distribution of the object beam on the Fourier surface.

According to the invention, the information can be recorded without requiring positioning of a phase mask and without causing spreading of the reference beams on a light collecting spot, and the information thus recorded can be recorded.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 shows a hologram recording device and a record medium of a first embodiment.

Fig. 2 shows display regions of a spatial light modulator of the hologram recording device of the first embodiment.

Figs. 3A - 3C schematically illustrate 2:4 differential encoding.

Figs. 4A and 4B illustrate a modulation pattern of an object beam and an intensity distribution thereof on a Fourier surface.

Figs. 5A and 5B illustrate a modulation pattern of a record reference beam and an intensity distribution thereof on a Fourier surface.

Figs. 6A and 6B illustrate a pattern of modulation displayed by a spatial light modulator of the hologram recording device of the first embodiment and an intensity distribution on a Fourier surface of a light flux formed of a combination of the object beam and the record reference beam.

Figs. 7A and 7B illustrate a pattern of modulation applied to the record reference beam and having a spatial frequency different from that of the modulation applied to the object beam as well as an intensity distribution thereof on a Fourier surface.

Figs. 8A and 8B illustrate a pattern of modulation applied to the record reference beam and having a spatial frequency different from that of the modulation applied to the object beam as well as an intensity distribution thereof on a Fourier surface.

Fig. 9 shows a hologram reproducing device and a record medium of the first embodiment.

Fig. 10 shows display regions of a spatial light modulator of the hologram reproducing device of the first embodiment.

Fig. 11 shows a hologram recording device and a record medium of a second embodiment.

Fig. 12 shows display regions of a spatial light modulator of the hologram recording device of the second embodiment.

Figs. 13A - 13C schematically illustrate 3-16 encoding.

Figs. 14A and 14B schematically illustrate 1:2 differential encoding and a pattern of modulation of the record reference beam produced in the modulation method using it.

Figs. 15A and 15B schematically illustrate a pattern of 3-16 modulation applied to the object beam as well as an intensity distribution on a Fourier surface.

Fig. 16 illustrates a pattern of modulation applied by a spatial light modulator of the hologram recording device of the second embodiment.

Fig. 17 shows a hologram reproducing device and a record medium of the second embodiment.

Fig. 18 shows display regions of the spatial light modulator of the hologram reproducing device of the second embodiment.

Fig. 19 illustrates an example of an object beam used for recording information by hologram.

Fig. 20 illustrates an intensity distribution on a Fourier surface of the object beam.

Fig. 21 shows a hologram record/reproduction device disclosed in Japanese Patent Laying-Open No. 2005-241773.

DESCRIPTION OF THE PREFERRED EMBODIMENTS

Embodiments according to the invention will be described below with reference to the drawings.

[First Embodiment]

(Hologram Recording Device)

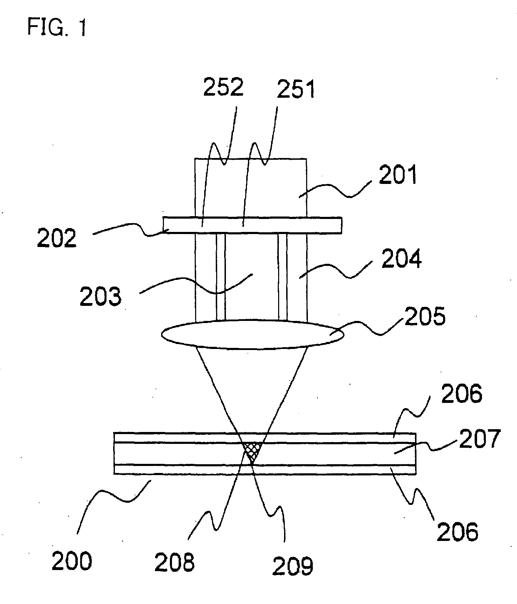

Fig. 1 shows a hologram recording device and a record medium of a first embodiment.

Referring to Fig. 1, this hologram recording device includes a spatial light modulator 202 and an objective lens 205.

A light source (not shown) emits a laser beam 201.

Spatial light modulator 202 receives laser beam 201, and provides a beam that is subjected to two-dimensional spatial light modulation. Spatial light modulator 202 is achieved, e.g., by a liquid crystal display device or a DMD (Digital Mirror Device). Spatial light modulator 202 includes a first spatial light modulator 251 providing an object beam 203 representing information to be recorded, and a second spatial light modulator 252 providing a record reference beam (i.e., a reference beam for recording) 204.

Objective lens 205 collects or converges object beam 203 and record reference beam 204 provided from spatial light modulator 202.

A record medium 200 is formed of a photosensitive material 207 and a substrate 206. Object beam 203 and record reference beam 204 passed through objective lens 205 interfere with each other in record medium 200, and are recorded as a hologram 208 on record medium 200.

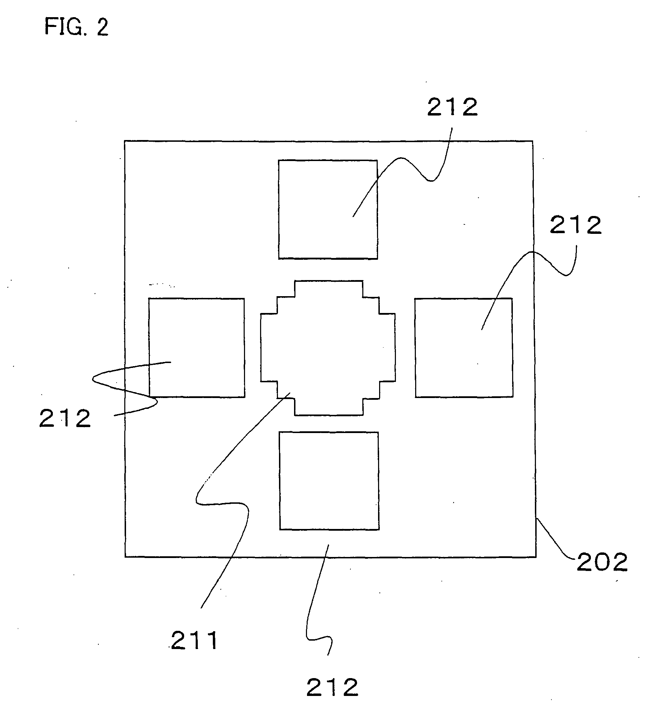

Fig. 2 shows display regions of spatial light modulator 202.

Referring to Fig. 2, the display regions of spatial light modulator 202 include an object beam display region 211 in first spatial light modulator 251 and record reference beam display regions 212 in second spatial light modulator 252.

Object beam display region 211 in first spatial light modulator 251 displays two-dimensional page data prepared by 2:4 differential encoding of information (image data) to be recorded. A controller (not shown) transmits this two-dimensional page data.

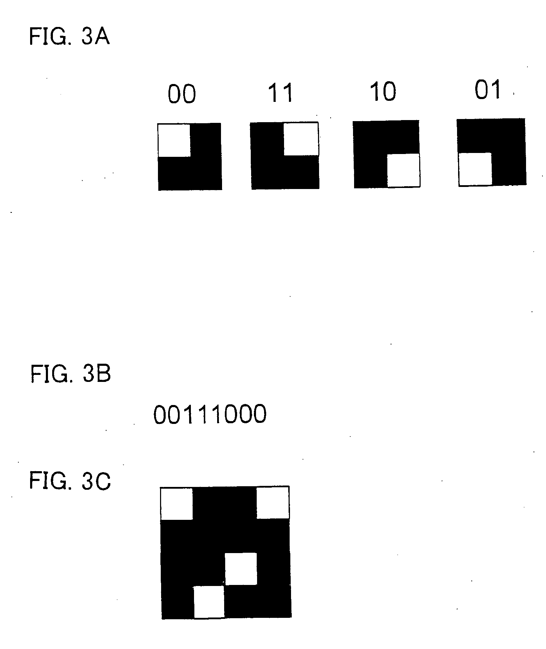

Then, the 2:4 differential encoding will be described. The 2:4 differential encoding is a modulation method that represents eight bits, using (4 x 4) pixels. In the 2:4 differential encoding, information (2 bits) is represented using a unit formed of (2 x 2) pixels according to a rule illustrated, e.g., in Fig. 3A. In Fig. 3 illustrating liquid crystal elements, open pixels are transparent pixels, and solid pixels are opaque pixels. In the unit formed of (2 x 2) pixels, only one pixel passes the beam therethrough, and the other three pixels intercept the beams. These pixels can pass or intercept the beams in four ways, and thus one unit corresponds to two bits. It is not essential that each pixel is one of the pixels of the spatial light modulator, and may be a set or collection of a plurality of pixels.

Fig. 3C represents a result of the 2:4 differential encoding performed on a bit string of 8 bits in Fig. 3B. The bit string in Fig. 3B is divided into units each including two neighboring bits, and each unit corresponding to the two bits is specifically determined according to the rule in Fig. 3A, and the specified units are arranged in the order of upper left, upper right, lower left and lower right positions in Fig. 3C, respectively.

As described above, the minimum pattern of the 2:4 differential encoding is formed of the four units each formed of (2 x 2) pixels. According to the 2:4 differential encoding, four bright spots in 16 pixels are used for representing a string of 8 bits. Therefore, according to the 2:4 differential encoding, the encoding patterns of 256 in number are present as the minimum patterns for representing eight bits.

Since the two-dimensional page data represented in object beam display region 211 of first spatial light modulator 251 is subjected to the 2:4 differential encoding as described above, the minimum pattern is formed of two bits regardless of details of the information (image data), and therefore always has a predetermined frequency component. Therefore, object beam display region 211 performs the amplitude modulation on incoming laser beam 201 to produce object beam 203 having the predetermined frequency component described above.

Each record reference beam display region 212 in second spatial light modulator 252 displays two-dimensional page data produced by the 2:4 differential encoding of the image data including on states and off states in a random fashion. A controller (not shown) provides this two-dimensional page data. Since the two-dimensional page data is already subjected to the 2:4 differential encoding, the two-dimensional have the same frequency component. Each record reference beam display region 212 performs the amplitude modulation on incoming laser beam 201 to produce record reference beam 204 having the same frequency component as object beam 203.

In the first embodiment, the minimum patterns of 256 in number produced by the 2:4 differential encoding are arranged in a random fashion in record reference beam display region 212, and thereby the modulation is applied to record reference beam 204. This manner is employed because the intensity distribution on a Fourier surface concentrates in a specific region when similar patterns neighbor to each other and repeat, or when only a few or several kinds of patterns cyclically appear.

In spatial light modulator 202, the beams pass through portions other than object beam display region 211 and record reference beam display regions 212. Although the first embodiment includes four reference beam display regions 212, this structure is not restrictive, and the display pattern may be of either a multiple type or a single type. Each display region may have a shape other than that already described.

(Intensity Distribution on the Fourier Surface)

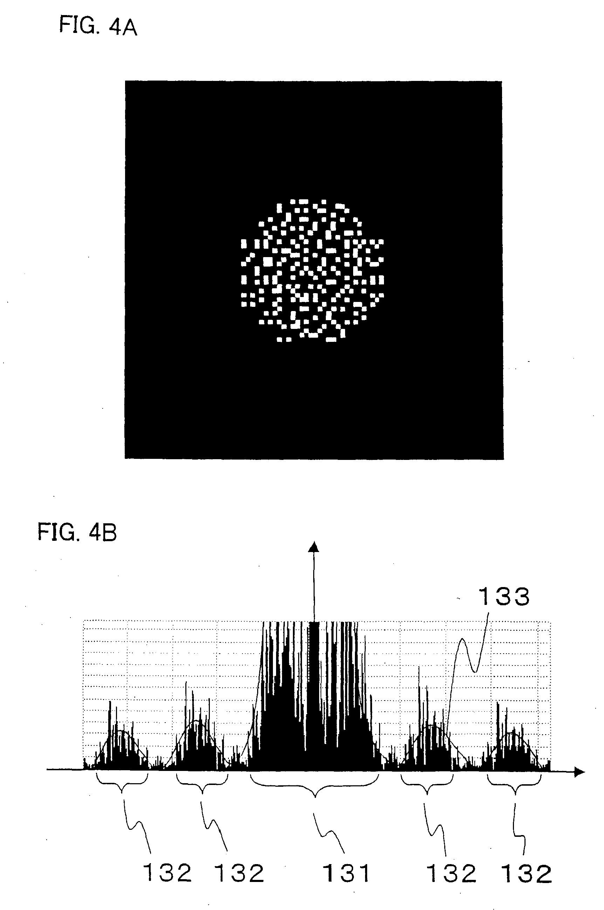

Then, description will be given on modulation patterns of the object beam and the reference beam used in the first embodiment as well as the intensity distribution near a focus of objective lens 205, i.e., on a Fourier surface 209 with reference to Figs. 4 to 6.

Fig. 4A shows a pattern of the modulation applied to object beam 203 in the first embodiment. In the figure, light is present in white points, and light is intercepted in black points.

Fig. 4B is a graph illustrating the intensity distribution exhibited on the Fourier surface when objective lens 205 collects only object beam 203 in the first embodiment. In this graph, the abscissa gives the frequency, and the ordinate gives the intensity on the Fourier surface.

Referring to Fig. 4B, an intensity distribution 131 of low frequency components (zeroth beam) of object beam 203 is present at and near the center, and other peaks are present in intensity distributions 132 of high frequency components of object beam 203.

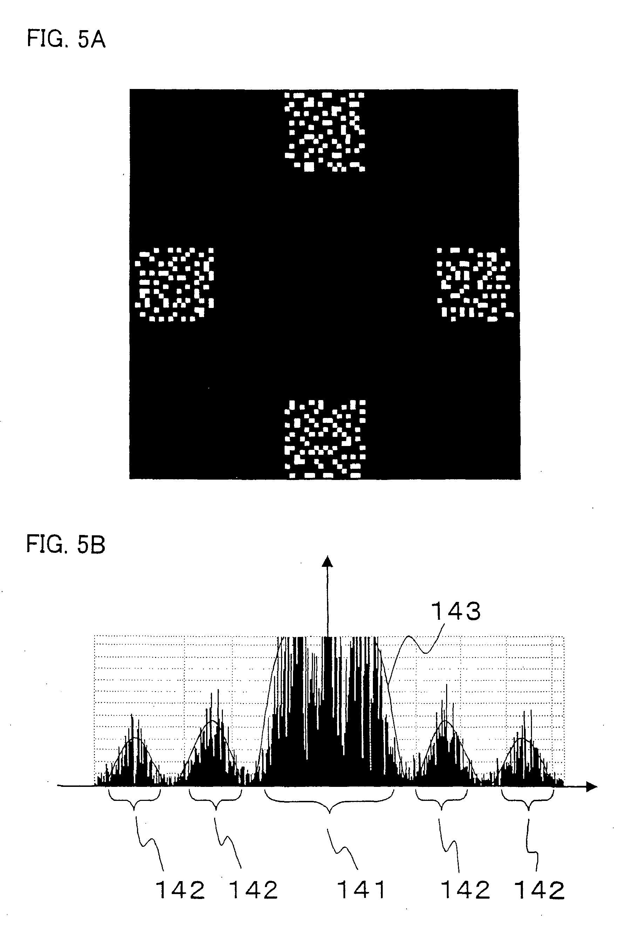

Fig. 5A illustrates a pattern of the modulation applied to record reference beam 204 in the first embodiment. In Fig. 5A, light is present in white points, and is intercepted in black points. For producing record reference beam 204, spatial light modulator 202 displays two-dimensional page data in record reference beam display regions 212, and this two-dimensional page data is produced by modulating random data in the modulation method (2:4 differential encoding) similar to the modulation method used for producing object beam 203.

Fig. 5B is a graph illustrating the intensity distribution exhibited on the Fourier surface when objective lens 205 collects only record reference beam 204 in the first embodiment. In this graph, the abscissa gives the frequency, and the ordinate gives the intensity on the Fourier surface.

Referring to Fig. 5B, an intensity distribution 141 of low frequency components (zeroth beam) of record reference beam 204 is present at and near the center, and other peaks are present in intensity distributions 142 of high frequency components of record reference beam 204.

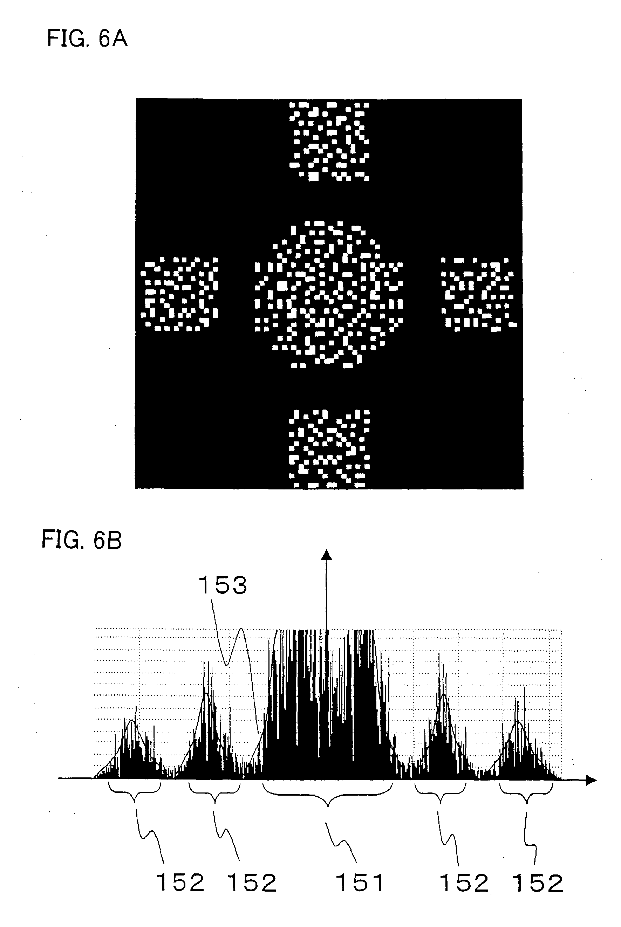

Fig. 6A illustrates a pattern of the modulation performed for recording, and this pattern is displayed by spatial light modulator 202. In Fig. 6A, light is present in white points, and is intercepted in black points. The modulation pattern in Fig. 6A is a combination of the modulation pattern of object beam 203 in Fig. 4A and the modulation pattern of record reference beam 204 in Fig. 5A.

Fig. 6B is a graph illustrating the intensity distribution on the Fourier surface of the light flux formed of a combination of object beam 203 and record reference beam 204 provided by spatial light modulator 202 in the first embodiment. In this graph, the abscissa gives the frequency, and the ordinate gives the intensity on the Fourier surface.

Referring to Fig. 6B, an intensity distribution 151 of low frequency components is present at and near the center, and intensity distributions 152 of high frequency components are present as the other intensity distributions. These intensity distributions provide the refractivity modulation on record medium 200 to form the hologram.

Since object beam 203 and record reference beam 204 provided from spatial light modulator 202 have the same spatial frequency components, the peak positions of an envelope 133 in Fig. 4B match the peak positions of an envelope 143 illustrated in Fig. 5B in the low and high frequency component regions.

In Fig. 6B, intensity distribution 131 of the low frequency components of object beam 203 appears in the same position as intensity distribution 141 of the low frequency components of record reference beam 204. Consequently, intensity distributions 131 and 141 in the positions matching together are superimposed together to exhibit intensity distribution 151. Also, intensity distributions 132 of the high frequency components of object beam 203 appear in the same positions as intensity distributions 142 of the high frequency components of record reference beam 204. Consequently, intensity distributions 132 and 142 in the positions matching together are superimposed together to exhibit intensity distributions 152. Thereby, the hologram can be formed without wasting the dynamic range of the record medium.

Then, description will be given on an influence that appears when the spatial frequency of the modulation applied to record reference beam 204 is different from that of the modulation applied to object beam 203.

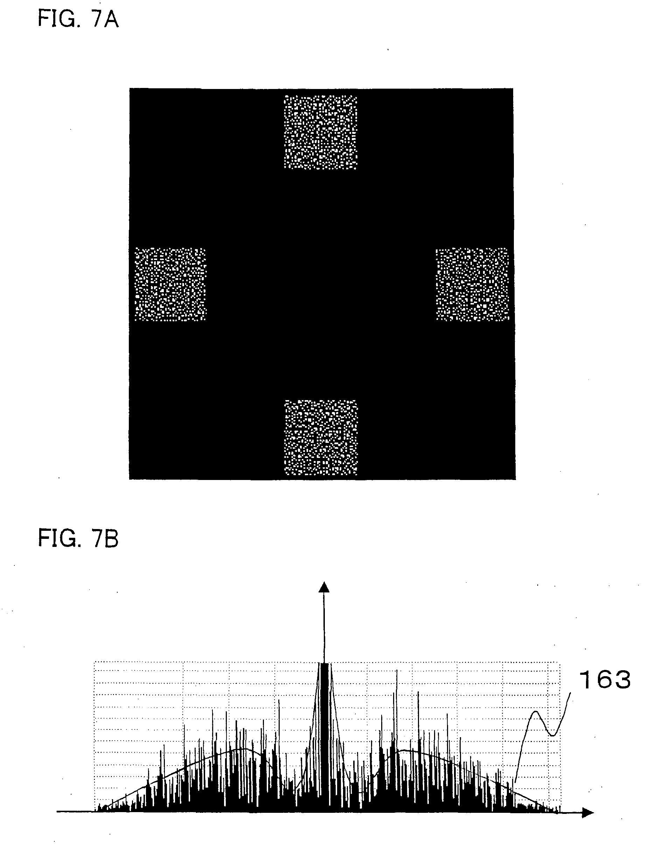

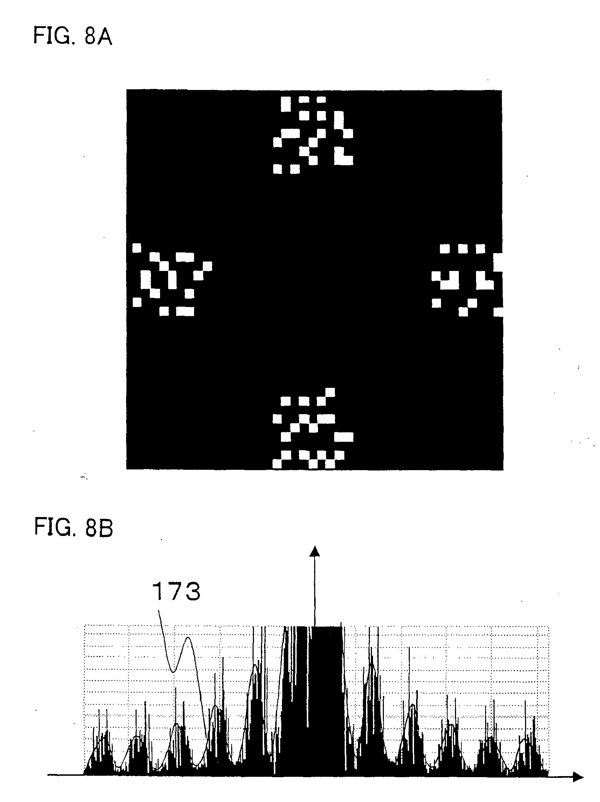

Figs. 7A and 8A illustrate a pattern of the modulation applied to the record reference beam that has the spatial frequency different from that of the modulation applied to object beam 203. Figs. 7B and 8B illustrate the intensity distribution on the Fourier surface. In these graph, the abscissa gives the frequency, and the ordinate gives the intensity on the Fourier surface. In both Figs. 7A and 7B, 2:4 differential encoding is performed.

The intensity distributions in Figs. 7B and 8B are significantly different from the intensity distribution on the Fourier surface of object beam 203 illustrated in Fig. 4B. Therefore, if the recording is performed using the patterns of the modulation of the record reference beam illustrated in Figs. 7B and 8B, this results in wasteful exposure on the record medium. Thus, the dynamic range of the record medium is wasted if the modulation having the spatial frequency different from that for object beam 203 is applied to the record reference beam.

(Operation of Recording Information)

Description will now be given on a recording operation of the hologram recording device.

Laser beam 201 provided from the light source (not shown) is led to spatial light modulator 202.

First spatial light modulator 251 of spatial light modulator 202 spatially modulates laser beam 201 by the 2:4 differential encoding to represent the information to be recorded, and provides object beam 203 having a predetermined frequency component. Second spatial light modulator 252 of spatial light modulator 202 spatially modulates laser beam 201 by the 2:4 differential encoding to provide record reference beam 204 having the frequency component equal to the above predetermined frequency component.

Then, objective lens 205 converges object beam 203 and record reference beam 204 provided from spatial light modulator 202 onto record medium 200. Object beam 203 and record reference beam 204 interfere with each other in record medium 200, and are recorded as hologram 208 on record medium 200.

(Hologram Reproducing Device)

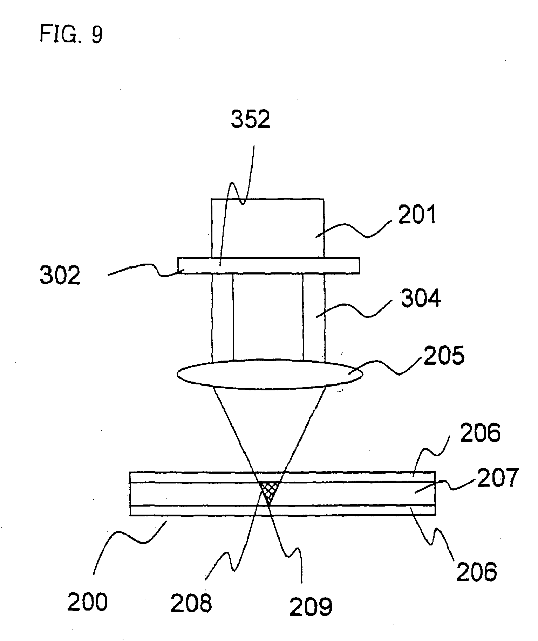

Fig. 9 shows the hologram reproducing device and the record medium of the first embodiment.

In Fig. 9, the same components as those in Fig. 1 bear the same reference numbers, and description thereof is not repeated.

A spatial light modulator 302 receives laser beam 201 to provide a beam that is subjected to two-dimensional spatial light modulation. Spatial light modulator 302 includes a second spatial light modulator 352 providing a reproduction reference beam 304.

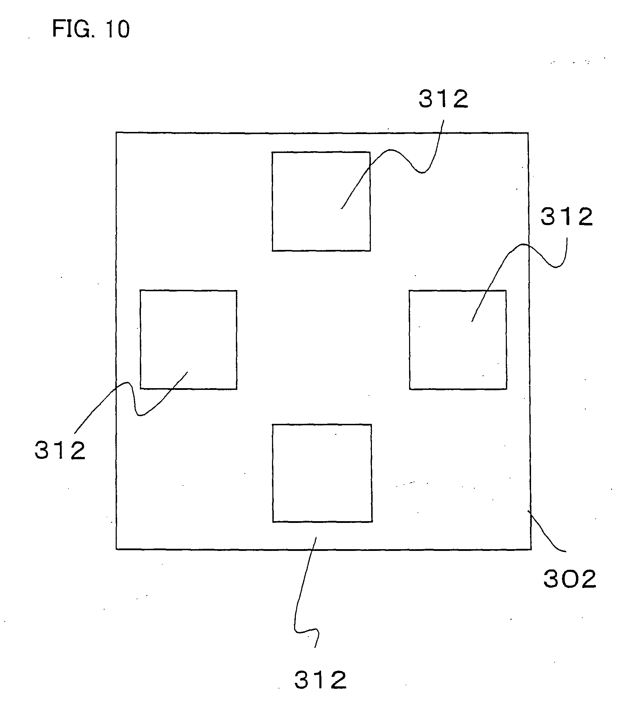

Fig. 10 represents display regions of spatial light modulator 302.

Referring to Fig. 10, a reproduction reference beam display region (i.e., a reference beam display region for reproduction) 312 in second spatial light modulator 352 of spatial light modulator 302 is substantially the same as record reference beam display region 212 in Fig. 2. More specifically, each reproduction reference light modulator 312 in second spatial light modulator 352 displays two-dimensional page data produced by performing 2:4 differential encoding on the image data including on states and off states in a random fashion. A controller (not shown) transmits this two-dimensional page data. Since this two-dimensional page data has undergone the 2:4 differential encoding, the two-dimensional page data displayed in record reference beam display region 212 has the same frequency components as the two-dimensional page data displayed in object beam display region 211 and the two-dimensional page data displayed in record reference beam display region 212. Since reproduction reference beam 304 provided from spatial light modulator 302 has the same spatial frequency components as object beam 203 provided from spatial light modulator 202 of the hologram recording device, the peak positions of the envelopes thereof match together in the low and high frequency component regions on the Fourier surface.

Each reproduction reference beam display region 312 performs the amplitude modulation on incoming laser beam 201 to produce reproduction reference beam 304 having the same frequency component as record reference beam 204.

(Operation of Reproducing Information)

Laser beam 201 emitted from the light source (not shown) is led to spatial light modulator 302.

Second spatial light modulator 352 of spatial light modulator 302 spatially modulates laser beam 201 by the 2:4 differential encoding to provide reproduction reference beam 304 that has the same frequency components as record reference beam 204 and object beam 203.

Then, objective lens 205 converges reproduction reference beam 304 provided from spatial light modulator 302 onto record medium 200. Reproduction reference beam 304 is applied to hologram 208, and object beam 203 is reproduced by the diffraction of hologram 208.

According to the hologram recording device and hologram reproducing device of the first embodiment, as described above, object beam 203, record reference beam 204 and reproduction reference beam 304 have the same spatial frequency components so that the positioning of the phase mask is not required. Also, the information can be recorded without causing spreading of the reference beam on the light conversion spot, and the information thus recorded can be reproduced.

[Second Embodiment]

(Hologram Recording Device)

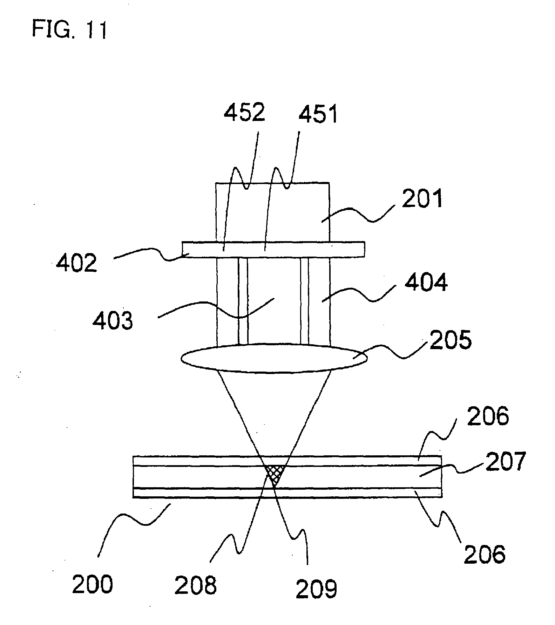

Fig. 11 shows a hologram recording device and a record medium of a second embodiment.

In Fig. 11, the same components as those in Fig. 1 bear the same reference numbers, and description thereof is not repeated.

A spatial light modulator 402 receives laser beam 201, and provides a beam that is spatially modulated in the two-dimensional fashion. Spatial light modulator 402 is achieved, e.g., by a liquid crystal display device and a DMD (Digital Mirror Device). Spatial light modulator 402 includes a first spatial light modulator 451 providing an object beam 403 representing information to be recorded, and a second spatial light modulator 452 providing a record reference beam 404.

Fig. 2 shows display regions of spatial light modulator 402.

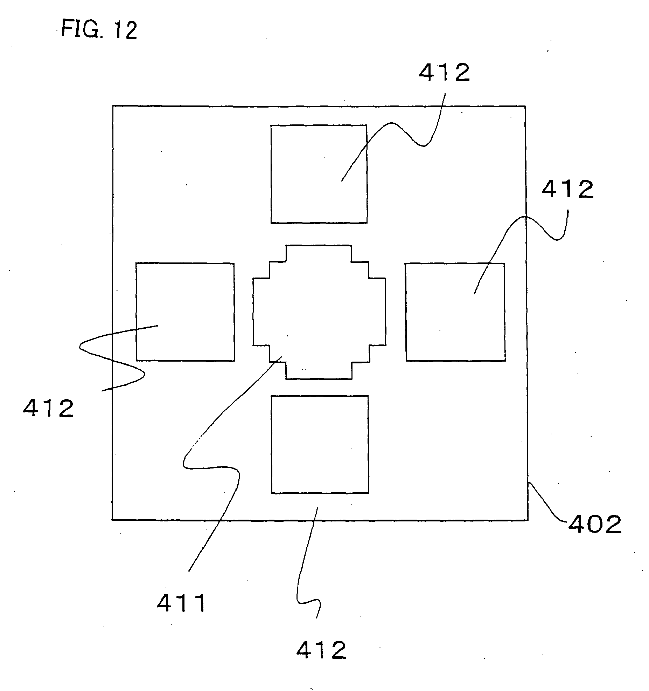

Referring to Fig. 12, spatial light modulator 402 includes an object beam display region 411 in first spatial light modulator 451 and record reference beam display regions 412 in second spatial light modulator 452.

Object beam display region 411 in first spatial light modulator 451 displays two-dimensional page data prepared by 3-16 encoding of information (image data) to be recorded. A controller (not shown) transmits this two-dimensional page data.

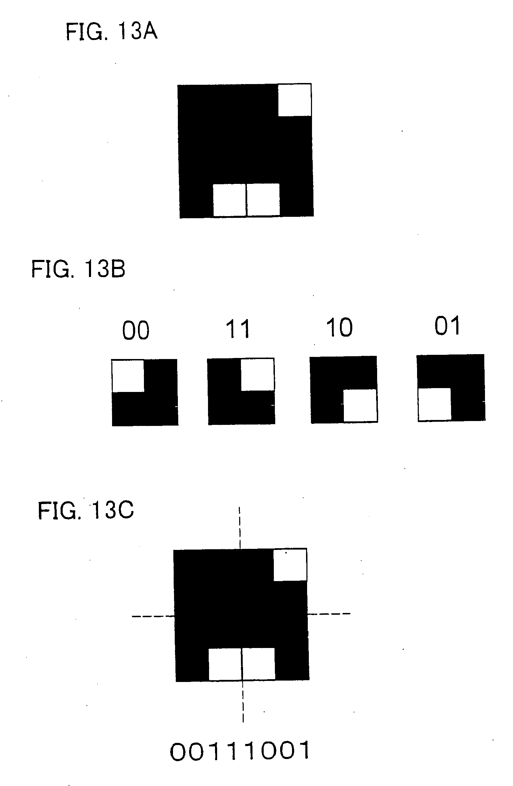

Then, the 3-16 encoding will be described. The 3-16 encoding is a modulation method that represents eight bits, using (4 x 4) pixels. In contrast to the 2:4 differential encoding, the 3-16 encoding is configured to represent eight bits, using three pixels among (4 x 4) pixels as illustrated in Fig. 13A.

Similarly to the 2:4 differential encoding, the 3-16 encoding uses units each having two bits of information formed of (2 x 2) pixels as illustrated in Fig. 13B. However, the 3-16 encoding uses only three or fewer units illustrated in Fig. 13B, and the light to the remaining (2 x 2) pixels is intercepted. These light-intercepted (2 x 2) pixels among the (4 x 4) pixels are present in the upper right, lower right, upper left or lower left position. Depending on this position, two bits (e.g., first two bits) in the eight-bit string are represented. When the light-intercepted (2 x 2) pixels among the (4 x 4) pixels are present in the upper right, lower right, upper left or lower left position, the first two bits in the eight-bit string represent, e.g., "00", "01", "10" or "11".

For example, in the pattern illustrated in Fig. 13C, the light-intercepted (2 x 2) pixels are present in the upper left position so that the first two bits in the eight-bit string represent "00". Other pixels are determined according to the rule in Fig. 13B so that the upper right pixels represent "11", lower left pixels represent "10", and lower right pixels represent "01". Accordingly, the pattern illustrated in Fig. 13C represents the bit string of "00111001".

In the 3-16 encoding, encoding patters of 256 in number are present as the minimum patterns for representing eight bits. In the 3-16 encoding, the transparent pixels neighboring to each other are two in number at most. Therefore, the positions of the intensity distributions other than the low frequency components on the Fourier surface of the object beam subjected to the 3-16 encoding match the positions of the intensity distribution other than the low frequency components of the record reference beam subjected to the 2:4 differential encoding.

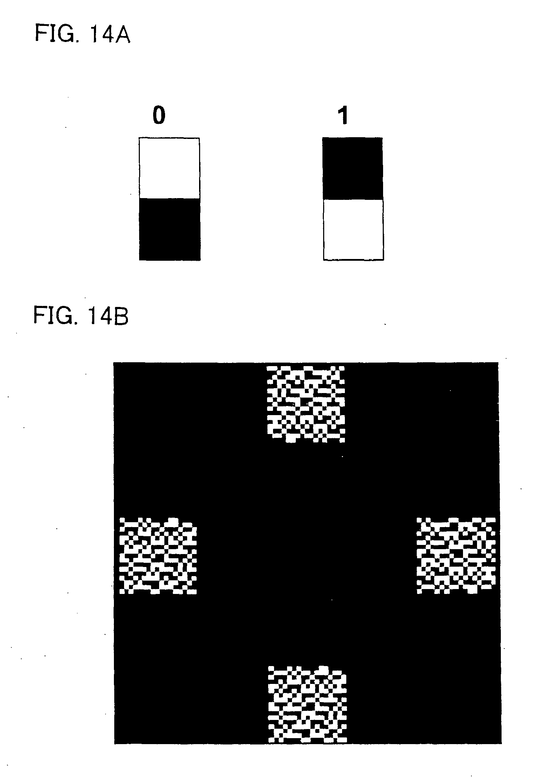

In contrast to the above, the object beam may be modulated by the 3-16 encoding, and the record reference beam may be modulated by the 1:2 differential encoding (differential encoding) that represents one bit by two pixels as illustrated in Fig. 14A. This will be described below. Fig. 14B illustrates an example of a pattern of the record reference beam subjected to the 1:2 differential encoding,

The object beam modulated by the 3-16 encoding provides two neighboring bright spots at the most, but the record reference beam modulated by the 1:2 differential modulation provides neighboring transparent pixels of two or more in the maximum number. Thus, the maximum number of the transparent pixels provided by the object beam is different from that provided by the record reference beam. In this case, the light intensity of the low frequency components of the record reference beam increases on the Fourier surface, and the interference of the low frequency components becomes predominant in the formation of the hologram. When the interference of the low frequency components becomes predominant, the high frequency components contribute to the image obtained by the reproduction to a relatively low extent so that the edge of each pixel is blurred in the reproduced image, resulting in increase in bit error. Further, the light intensity of the low frequency components increases so that the dynamic range of the record medium is wasted.

For avoiding the above problem, the second embodiment is configured to modulate the object beam by the 3-16 encoding, and to modulate the record reference beam by the 2:4 differential encoding so that each light flux may contain the neighboring bright spots of two at the most.

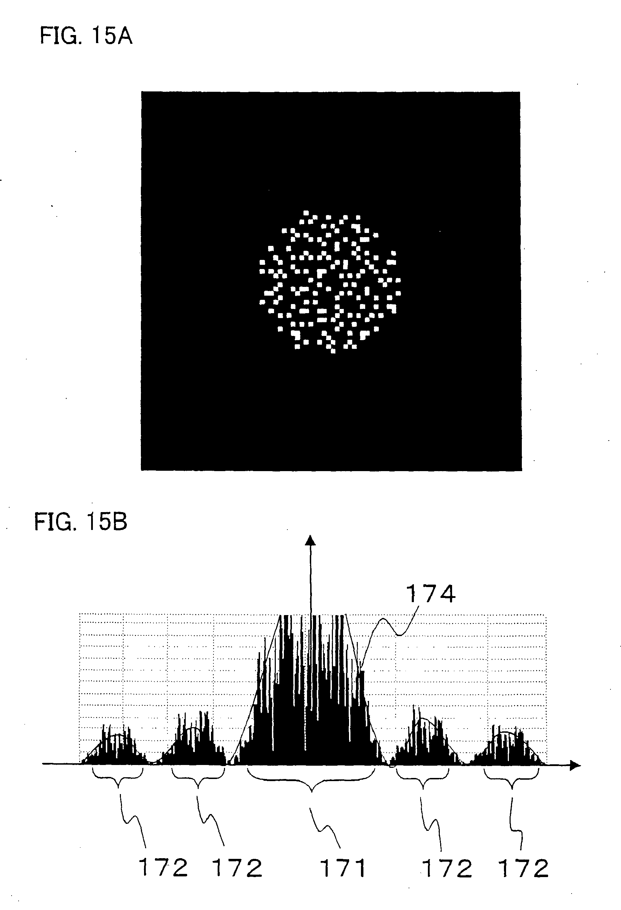

Fig. 15A is a display pattern of the object beam modulated by the 3-16 encoding. Fig. 15B illustrates an intensity distribution on the Fourier surface of the object beam produced from the display pattern in Fig. 15A. In this graph, the abscissa gives the frequency, and the ordinate gives the intensity on the Fourier surface. Referring to Fig. 15B, an intensity distribution 171 of low frequency components (zeroth beam) of the object beam is present at and near the center. Intensity distributions 172 of high frequency components of the object beam are present as the other intensity distributions. Referring to Figs. 15B and 5B, the positions of intensity distributions 172 of the high frequency components of the object beam modulated by the 3-16 encoding match, on the Fourier surface, the positions of intensity distributions 142 of the high frequency components of the record reference beam modulated by the 2:4 differential encoding. Thus, in the region other than the low frequency components, the object beam modulated by the 3-16 modulation has the same frequency components as the record reference beam modulated by the 2:4 differential encoding. In the region other than the low frequency components, the peak positions of envelopes 174 and 143 illustrated in Figs. 15B and 5B match each other.

The patterns in each of record reference beam display regions 412 in second spatial light modulator 452 are arranged such that the same minimum patterns among the 256 minimum patterns produced by the 2:4 differential encoding may not neighbor each other. The controller (not shown) provides the page data of record reference beam display region 412 thus set.

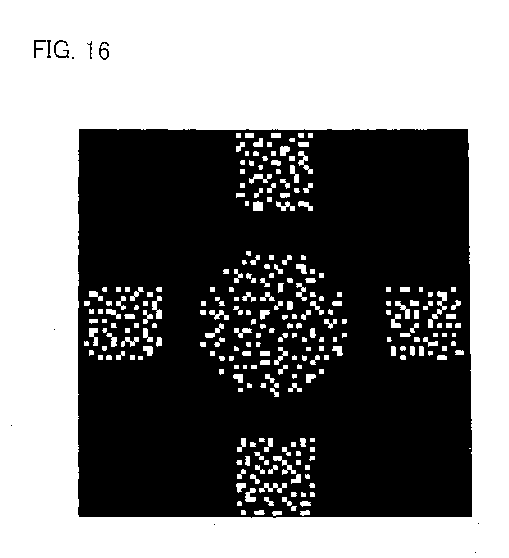

Fig. 16 illustrates a pattern of the modulation displayed in spatial light modulator 402 in the recording operation. In Fig. 16, the light is present in white points, and is intercepted in black points. The pattern of modulation in Fig. 16 is a combination of the pattern of modulation of object beam 403 modulated by the 3-16 encoding and a pattern of modulation of record reference beam 404 modulated by the 2:4 differential encoding.

The amplitude modulation is performed on incoming laser beam 201 in each of record reference beam display regions 412 to produce, on the Fourier surface, record reference beam 404 having the same frequency components as object beam 403 in the region other than the low frequency components.

Spatial light modulator 402 is configured to intercept the light in the display region other than object beam display region 411 and record reference beam display region 412. In the second embodiment, record reference beam display regions 412 are four in number. However, this is not restrictive, and multiple or single display patterns may be employed. Also, each display region may take a form other than the above.

(Operation of Recording Information)

Then, the operation of the hologram recording device for recording will be described.

Laser beam 201 provided from the light source (not shown) is led to spatial light modulator 402.

First spatial light modulator 451 of spatial light modulator 402 spatially modulates laser beam 201 by the 3-16 encoding to represent the information to be recorded, and provides object beam 403 having a predetermined intensity distribution on the Fourier surface. Second spatial light modulator 452 spatially modulates laser beam 201 by the 2:4 differential encoding to provide record reference beam 404 having the frequency component equal to the above predetermined frequency component in the region except for the low frequency components.

Then, objective lens 205 converges object beam 403 and record reference beam 404 provided from spatial light modulator 402 onto record medium 200. Object beam 403 and record reference beam 404 interfere with each other in record medium 200, and are recorded as hologram 208 on record medium 200.

(Hologram Reproducing Device)

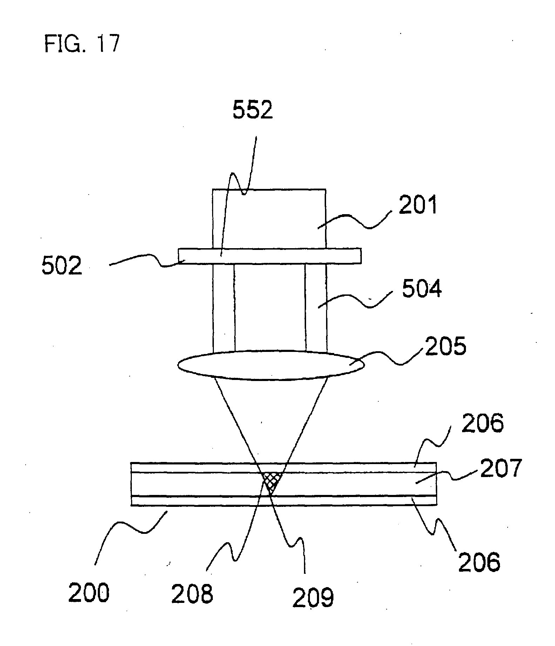

Fig. 17 represents the hologram reproducing device and the record medium of the second embodiment.

In Fig. 17, the same components as those in Fig. 1 bear the same reference numbers, and description thereof is not repeated.

A spatial light modulator 502 receives laser beam 201 to provide a beam that is subjected to the two-dimensional spatial light modulation. Spatial light modulator 502 includes a second spatial light modulator 552 providing a reproduction reference beam 504.

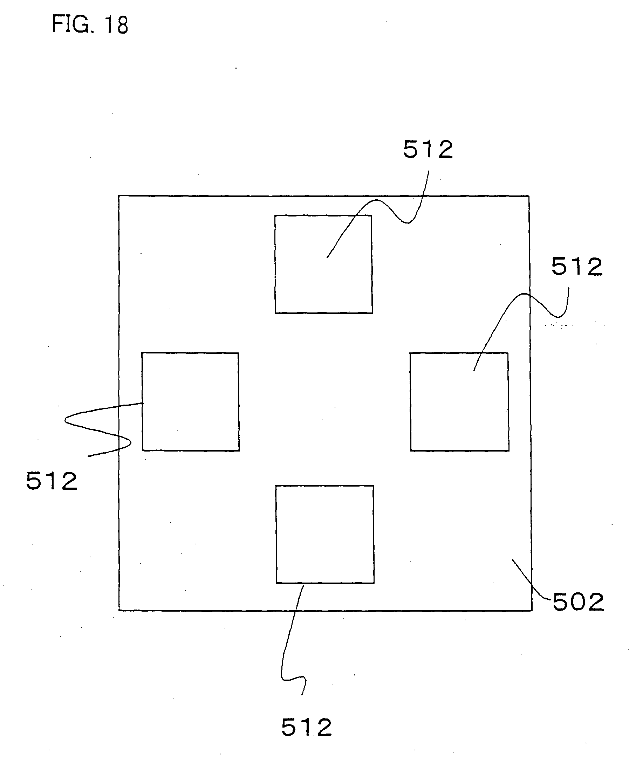

Fig. 18 represents display regions of spatial light modulator 302.

Referring to Fig. 10, a reproduction reference beam display region 512 in second spatial light modulator 552 of spatial light modulator 502 is substantially the same as record reference beam display region 412 in Fig. 12.

The amplitude modulation is performed on incoming laser beam 201 in each reproduction reference beam display region 512 to produce reproduction reference beam 504 having the same frequency components as object beam 403 in the region other than the low frequency components. More specifically, second spatial light modulator 552 provides reproduction reference beam 504 having such intensity distributions that the peak positions of the envelope in the region other than the low frequency components on the Fourier surface of reproduction reference beam 50 match the peak positions of the envelope in the region except of the low frequency components in the intensity distribution on the Fourier surface of object beam 403.

(Operation of Reproducing Information)

The reproducing operation of the hologram reproducing device will now be described.

Laser beam 201 emitted from the light source (not shown) is led to spatial light modulator 502.

Second spatial light modulator 552 of spatial light modulator 502 spatially modulates laser beam 201 by 2:4 differential encoding to provide reproduction reference beam 504 that has the same frequency components as object beam 203 in the region other than the low frequency components.

Then, objective lens 205 converges reproduction reference beam 504 provided from spatial light modulator 502 onto record medium 200. Reproduction reference beam 504 is applied to hologram 208, and object beam 403 is reproduced by the diffraction of hologram 208.

According to the hologram recording device and the hologram reproducing device of the second embodiment, as described above, object beam 403, record reference beam 404 and reproduction reference beam 504 exhibit, on the Fourier surface, the intensity distributions of which positions except for the low frequency components match each other. Therefore, the information can be recorded without requiring the positioning of the phase mask and without causing spreading of the reference beam on the light conversion spot, and the information thus recorded can be reproduced.

Although the present invention has been described and illustrated in detail, it is clearly understood that the same is by way of illustration and example only and is not to be taken by way of limitation, the spirit and scope of the present invention being limited only by the terms of the appended claims.

**Claims**

1. A hologram recording device for applying an object beam (203, 403) representing information and a record reference beam (204, 404) to a record medium (200) to record the information by recording, on said record medium (200), an interference fringe caused by said object beam (203, 403) and said record reference beam (204, 404), comprising:

    a spatial light modulator (202, 402) spatially modulating a light flux; and
    a lens (205) converging said modulated light flux onto said record medium (200), wherein

    said spatial light modulator (202, 402) includes:

    a first spatial light modulator (251, 451) spatially modulating said light flux to provide the object beam (203, 403) representing the information to be recorded and having a predetermined frequency component, and
    a second spatial light modulator (252, 452) spatially modulating said light flux to provide the record reference beam (204, 404) having a frequency component equal to said predetermined frequency component at least in a region except for a low frequency component; and

    said lens (205) simultaneously converges said object beam (203, 403) and said record reference beam (204, 404) onto said record medium (200).

2. The hologram recording device according to claim 1, wherein
said first and second spatial light modulators (251, 451; 252, 452) perform amplitude modulation on said incoming light flux.

3. The hologram recording device according to claim 1, wherein
said object beam (203) and said record reference beam (204) are spatially modulated in the same modulation method.

4. The hologram recording device according to claim 1, wherein
said object beam (403) and said record reference beam (404) are spatially modulated in different modulation methods, respectively, and a maximum number of neighboring bright spots in the modulation applied to said object beam (403) is equal to that in the modulation applied to said record reference beam (404).

5. The hologram recording device according to claims 3 and 4, wherein
a peak position of an envelope, in a region except for a low frequency component, of an intensity distribution of said record reference beam (204, 404) on a Fourier surface matches a peak position of an envelope, in the region, of an intensity distribution of said object beam (203, 403) on the Fourier surface.

6. A hologram reproducing device for reading information from a record medium (200) bearing an interference fringe caused by an object beam (203, 403) representing the information and a record reference beam (204, 404), comprising:

    a spatial light modulator (302, 502) spatially modulating a light flux to provide a reproduction reference beam (304, 504) having the same frequency component as said object beam (203, 403) at least in a region except for a low frequency component; and
    a lens (205) converging said reproduction reference beam (304, 504) onto said record medium (200).

7. The hologram reproducing device according to claim 6, wherein
said spatial light modulator (302, 502) performs amplitude modulation on said incoming light flux.

8. The hologram reproducing device according to claim 6, wherein
said reproduction reference beam (304) is spatially modulated in the same modulation method as said object beam (203).

9. The hologram reproducing device according to claim 6, wherein
said reproduction reference beam (504) is spatially modulated in a modulation method different from that of said object beam (403), and a maximum number of neighboring bright spots in the modulation applied to said object beam (403) is equal to that in the modulation applied to said reproduction reference beam (504).

10. The hologram reproducing device according to claims 8 and 9, wherein

a peak position of an envelope, in a region except for a low frequency component, of an intensity distribution of said reproduction reference beam (304, 504) on a Fourier surface matches a peak position of an envelope, in the region, of an intensity distribution of said object beam (203, 403) on the Fourier surface.

**11.** A hologram recording method for applying an object beam (203, 403) representing information and a record reference beam (204, 404) to a record medium (200) to record the information by recording, on said record medium (200), an interference fringe caused by said object beam (203, 403) and said record reference beam (204, 404), comprising the steps of:

> spatially modulating a light flux; and
> converging said modulated light flux onto said record medium (200), wherein

> > in said step of performing the modulation, said light flux is spatially modulated to provide the object beam (203, 403) representing the information to be recorded and having a predetermined frequency component, and said light flux is spatially modulated to provide the record reference beam (204, 404) having the same frequency component as said object beam (203, 403) at least in a region except for a low frequency component, and
> > in the step of converging the light flux, said object beam (203, 403) and said record reference beam (204, 404) are simultaneously converged onto said record medium (200).

**12.** The hologram recording method according to claim 11, wherein
amplitude modulation is performed on the incoming light flux in said step of performing the modulation.

**13.** The hologram recording method according to claim 11, wherein
said object beam (203) and said record reference beam (204) are spatially modulated in the same modulation method in said step of performing the modulation.

**14.** The hologram recording method according to claim 11, wherein
in said step of performing the modulation, said object beam (403) and said record reference beam (404) are spatially modulated in different modulation methods, respectively, and a maximum number of neighboring bright spots in the modulation applied to said object beam (403) is equal to that in the modulation applied to said record reference beam (404).

**15.** The hologram recording method according to claims 13 and 14, wherein
said object beam (203, 403) and said record reference beam (204, 404) provided in said step of performing the modulation are configured such that a peak position of an envelope, in a region except for a low frequency component, of an intensity distribution of said record reference beam (204, 404) on a Fourier surface matches a peak position of an envelope, in the region, of an intensity distribution of said object beam (203, 403) on the Fourier surface.

**16.** A hologram reproducing method for reading information from a record medium (200) bearing an interference fringe caused by an object beam (203, 403) representing the information and a record reference beam (204, 404), comprising the steps of:

> spatially modulating a light flux to provide a reproduction reference beam (304, 504) having the same frequency component as said object beam (203, 403) at least in a region except for a low frequency component; and
> converging said reproduction reference beam onto said record medium.

**17.** The hologram reproducing method according to claim 16, wherein
amplitude modulation is performed on said incoming light flux in said step of performing the modulation.

**18.** The hologram reproducing method according to claim 16, wherein
said reproduction reference beam (304) and said object beam (203) are spatially modulated in the same modulation method in said step of performing the modulation.

**19.** The hologram reproducing method according to claim 16, wherein
in said step of performing the modulation, said reproduction reference beam (504) is spatially modulated in a modulation method different from that of said object beam (403), and a maximum number of neighboring bright spots in the modulation applied to said object beam (403) is equal to that in the modulation applied to said reproduction reference beam (504).

**20.** The hologram reproducing method according to claims 18 and 19, wherein
in said step of performing the modulation, the reproduction reference beam (304, 504) is provided such that a peak position of an envelope, in a region except for a low frequency component, of an intensity distribution of said reproduction reference beam (304, 504) on a Fourier surface matches a peak position of an envelope, in the region, of an intensity distribution of said object beam (203, 403) on the Fourier surface.

FIG. 1

FIG. 2

FIG. 3A

00    11    10    01

FIG. 3B

00111000

FIG. 3C

FIG. 4A

FIG. 4B

133

132    132    131    132    132

FIG. 5A

FIG. 5B

FIG. 6A

FIG. 6B

FIG. 7A

FIG. 7B

163

FIG. 8A

FIG. 8B

173

FIG. 9

FIG. 10

312

312

312

312

302

FIG. 11

FIG. 12

412

412

412

402

411

412

FIG. 13A

FIG. 13B

00　　　11　　　10　　　01

FIG. 13C

00111001

FIG. 14A

FIG. 14B

FIG. 15A

FIG. 15B

174

172  172       171       172  172

FIG. 16

FIG. 17

FIG. 18

512

512

512

502

512

FIG. 19

Y AXIS

X AXIS

FIG. 20

FIG. 21

EP 1 876 591 A2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006185840 A
- JP 2007129514 A

- JP 2005241773 A

### Non-patent literature cited in the description

- Holographic Data Storage. *IBM J. RES. DEVELOP,* May 2000, vol. 44 (3